# EUROPEAN PATENT APPLICATION

(11) **EP 2 346 307 A2**
(43) Date of publication of application: **20.07.2011**
(21) Application number: 11151127.5
(22) Date of filing: 17.01.2011
(51) Int. Cl.: H05K 1/02

(54) **Lighting Apparatus**

(30) Priority: 18.01.2010 JP 2010008614
(71) Applicant: Toshiba Lighting & Technology Corporation, Yokosuka-shi Kanagawa 237-8510 (JP)
(72) Inventor: Nashimura, Kiyoshi, Yokosuka-shi, Kanagawa 237-8510 (JP); Ogawa, Kozo, Yokosuka-shi, Kanagawa 237-8510 (JP); Shibusawa, Soichi, Yokosuka-shi, Kanagawa 237-8510 (JP)
(74) Representative: Kramer - Barske - Schmidtchen

(57) **Abstract**

According to one embodiment, a lighting apparatus includes a conductive main body (22) at a ground potential, a light-emitting device (1) in the main body, including an insulative substrate (2), a plurality of light-emitting elements (3) mounted on a front side of the substrate, a power feeding wiring (4) electrically connecting the light-emitting elements, and a conductor layer (6) on a backside of the substrate, electrically connected to the power feeding wiring at a potential higher than a ground potential, and a lighting control device configured to supply power to the light-emitting device.

## Description

### FIELD

Embodiments described herein relate generally to lighting apparatus using a light-emitting element such as a light-emitting diode (LED).

### BACKGROUND

A light-emitting diode has recently been used as a light source of lighting apparatus. In such a light source, a plurality of bare LED chips is mounted on a substrate, and each LED chip is electrically connected to a wiring pattern by a bonding wire. A plurality of such substrates is housed in a main body made of metal such as aluminum (Jpn. Pat. Appln. KOKAI Publication No. 2009-54989). Such lighting apparatus is usually powered by a lighting control device connected to an alternating-current source, and lighting of LED chips is controlled. The metal main body is maintained at a ground potential.

However, in the above-mentioned lighting apparatus, though a power switch (one-position) of the lighting control device is turned off, the LED chips may faintly light dusky. This erroneous lighting of the LED chips is caused by a noise superimposed on a power line. Stray capacitance is generated between a conductor such as the wiring pattern connected to the LED chips and the metallic main body close to the conductor, and a minute current as a leakage current flows in the LED chips.

As a method of preventing the erroneous lighting, a capacitor serving as a bypass element is connected in parallel to each LED chip to form a bypass for the minute current. However, with this method, the manufacturing cost is increased by adding the capacitors, and reliability of the wiring connection deteriorates due to increasing the number of parts to be soldered. Further, when the capacitors are mounted on the surface of the substrate, the reflectivity of the substrate surface is reduced, and an optical output of the light source is decreased.

### BRIEF DESCRIPTION OF THE DRAWINGS

FIG. 1 is a plan view of a light-emitting device in a lighting apparatus according to a first embodiment;
FIG. 2 is a plan view of the backside of the light-emitting device;
FIG. 3 is a plan view of a substrate of the light-emitting device, before a fluorescent layer is applied;
FIG. 4 is a sectional view of the lighting apparatus along line IV-IV in FIG. 1;
FIG. 5 is a connection diagram schematically showing the lighting apparatus;
FIG. 6 is a plan view of a light-emitting device of a lighting apparatus according to a second embodiment;
FIG. 7 is a plan view of the backside of the light-emitting device;
FIG. 8 is a plan view of the front side of the light-emitting device;
FIG. 9 is a sectional view of the light-emitting device along line IX-IX in FIG. 6; and
FIG. 10 is a plan view of an LED chip and power feeding wiring of the light-emitting device.

### DETAILED DESCRIPTION

In general, according to one embodiment, lighting apparatus comprises a conductive main body at a ground potential; a light-emitting device in the main body, comprising an insulative substrate, a plurality of light-emitting elements mounted on a front side of the substrate, a power feeding wiring electrically connecting the light-emitting elements, and a conductor layer on a backside of the substrate, electrically connected to the power feeding wiring at a potential higher than a ground potential; and a lighting control device configured to supply power to the light-emitting device.

A substrate may be made of synthetic resin such as glass epoxy resin, or may be composed of a base plate made of metallic material such as aluminum with an insulating layer formed on one side or both sides of the base plate. A light-emitting element is a solid light-emitting element such as a light-emitting diode (LED). The number of light-emitting elements to be mounted on a substrate is not limited. A method of mounting a light-emitting diode on a substrate is not limited. For example, a chip-on-board method directly inserts a bare chip into a substrate, and a soldering method solders packaged surface-mounted components.

A power feeding wiring means a conductor such as a bonding wire and a wiring pattern to electrically connect each light-emitting element. A conductor layer can be made by forming a copper foil pattern layer, for example. Material of a conductor layer is not limited as long as conductivity is ensured. A lighting apparatus includes a lighting fixture used indoor and outdoor, and a display.

According to an embodiment, in a lighting apparatus, a power feeding wiring and conductor layer are electrically connected by a conductive fixing means for fixing a substrate to an apparatus main body, and are set to substantially the same potential. A mounting screw may be used as a fixing means or fixing tool, for example. This makes it possible to use a means to fix a substrate to an apparatus main body as a means of setting a power feeding wiring and conductor layer at substantially the same potential.

According to an embodiment, in a lighting apparatus, a conductor layer is extended to the outside of an area in which a power feeding wiring is formed. In this configuration, the area of the conductor layer is increased, and a stray capacitance between the conductor layer and apparatus main body is increased, and a noise bypass effect is increased.

According to an embodiment, there is provided a lighting apparatus, which prevents false lighting of a light-emitting element by simple configuration. As a fixing means to fix a substrate to an apparatus main body is used as a means to set the same potential, the configuration is simplified. A conductor layer area is increased, and a stray capacitance between a conductor layer and main body is increased.

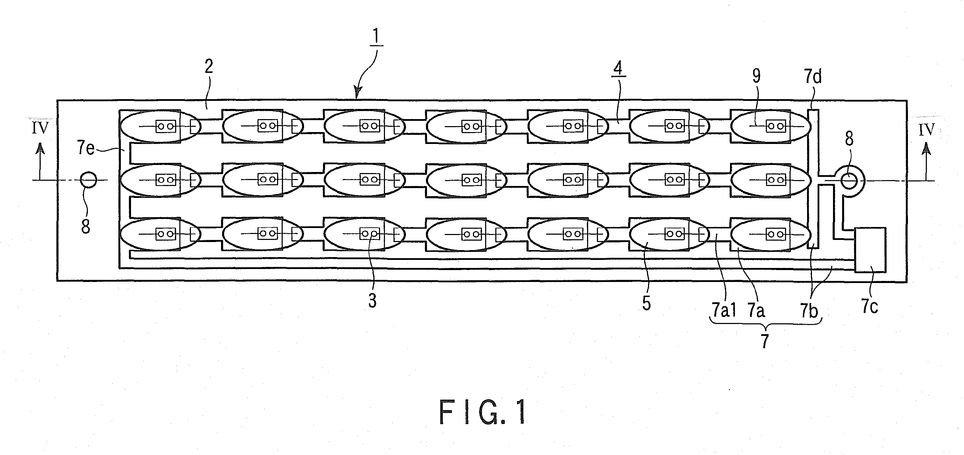

Hereinafter, a lighting apparatus according to a first embodiment will be explained with reference to FIGS. 1 to 5. The same parts in the drawings are given the same reference numbers, and an explanation thereof is omitted.

As shown in FIGS. 1 to 4, a light-emitting device 1 of a lighting apparatus comprises a substrate 2, a plurality of light-emitting elements 3 mounted on the front side of the substrate 2, a power feeding wiring 4 to electrically connect each light-emitting element 3, a fluorescent layer 5 to cover each light-emitting element 3, and a conductor layer 6 formed on the backside of the substrate 2.

The substrate 2 is formed substantially rectangular. The substrate 2 is made of insulating material to form an insulating layer, for example, synthetic resin such as glass epoxy resin, and has an insulating layer. The substrate 2 may be made of ceramics or other synthetic resin materials.

On the front side of the substrate 2, a wiring pattern 7 constituting a power feeding wiring 4 is formed. The wiring pattern 7 has a plurality of mounting pads 7a, on which the light-emitting elements 3 are mounted, and a power supply conductor 7b of a predetermined pattern, which electrically connects the mounting pads 7a. The mounting pads 7a are arranged in matrix on the surface of the substrate 2, and arranged in three lines, for example, in the longitudinal direction of the substrate 2. Each mounting pad 7a is shaped substantially rectangular, and a thin connection conductor 7a1 for connecting a bonding wire is extended from one short side in the direction orthogonal to this side.

The power supply conductor 7b has a negative electrode 7d and positive electrode 7e, which are provided at one end and the other end of each line of the mounting pad 7a, and a connector terminal 7c connected to these positive and negative electrodes. The connector terminal 7c is connected to a lead wire extended from a lighting control device 15, and is powered from the lighting control device.

At both ends of the longitudinal direction of the substrate 2, a screw through hole 8, through which a screw for fixing the substrate 2 to an apparatus main body 22 passes, is provided. Around one screw through hole (right side in FIG. 1), a power supply conductor 7b is formed on the substrate 2 and connected to the positive electrode 7d and connecter terminal 7c.

The wiring pattern 7 has a three-layer structure. A copper foil pattern is etched as a first layer on the surface of the substrate 2. On the copper foil pattern layer, an electroless nickel-plated layer is formed as a second layer, and an electroless silver (Ag) plated layer is formed on the electroless nickel-plated layer as a third layer. The third silver-plated layer of the wiring pattern, that is, the surface layer has a high total light reflectivity of 90%.

Each light-emitting layer 3 is made of a bare LED chip. For example, a bare chip 3 uses material to emit blue light, so that white light is emitted from a light-emitting part. The LED bare chip is bonded on the mounting pad 7a by using an insulative silicone resin adhesive. A plurality of bare chips 3 is arranged in matrix, forming lines of light-emitting elements, according to the array of the mounting pads 7a. Specifically, the bare chips 3 are mounted in 7 pieces by 3 rows, 21 pieces in total.

The bare chip 3 is an InGaN element, for example, with a light-emitting layer formed on a transparent sapphire element substrate. The light-emitting layer is formed by sequentially laminating an n-type nitride semiconductor layer, an InGaN light-emitting layer, and a p-type nitride semiconductor layer. An electrode to flow a current to a light-emitting layer comprises a positive electrode formed by a p-type electrode pad on the p-type nitride semiconductor layer, and a negative electrode formed by a n-type electrode pad on the n-type nitride semiconductor layer. The electrodes of the bare chip 3 are electrically connected to the wiring pattern 7 by a bonding wire 9. The bonding wire 9 is a gold (Au) thin wire, and is connected through a bump made mainly of gold (Au), to increase the mounting strength and to prevent damage of the bare chip 3. The power feeding wiring 4 is a means to electrically connect each light-emitting element 3, and is provided with a wiring pattern 7 and a bonding wire 9 in this embodiment.

The fluorescent layer 5 is made of transparent synthetic resin such as transparent silicon resin, and contains the right amount of fluorescent material. The fluorescent layer 5 individually covers and seals each light-emitting element 3 and bonding wire 9. The fluorescent layer 5 is formed to have an arc-shaped projection in its cross section. A fluorescent material is excited by the light emitted from the bare chip 3, and emits light of the color different from the light emitted from the bare chip 3. In this embodiment, as the bare chip 3 emits blue light, a yellow fluorescent material to emit yellow light that is a complementary color to the blue light is used, so that white light is emitted from the light-emitting device 1. The fluorescent layer 5 is applied to the bare chip 3 and bonding wire 9 in the uncured state, and then hardened by heating or leaving for a predetermined time.

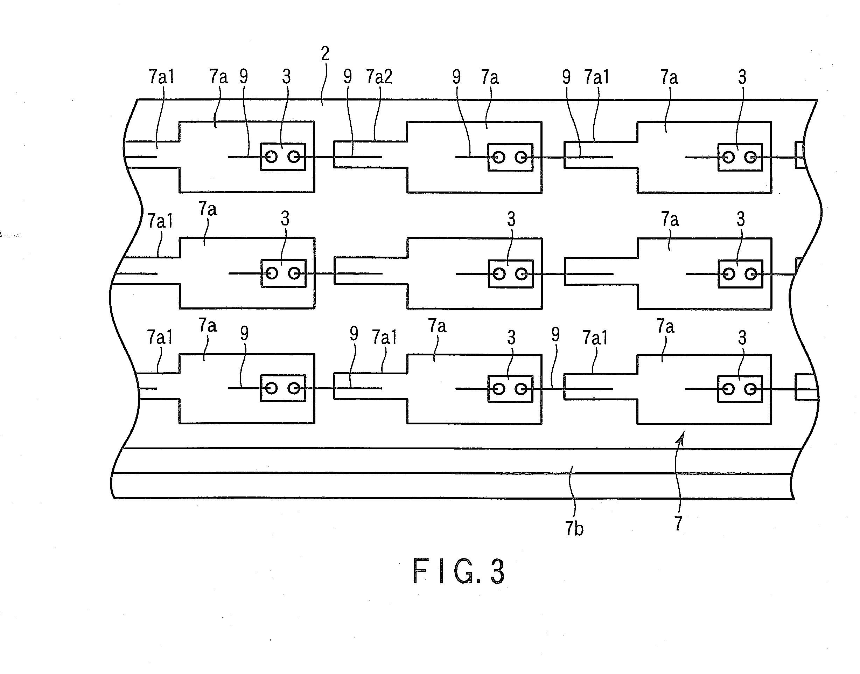

As shown in FIG. 3, among the lines of light-emitting elements, the positive and negative electrodes of the bare chip 3 in each line of light-emitting element are sequentially connected to the mounting pad 7a and a connection conductor 7a1 of an adjacent mounting pad 7a by the bonding wire 9. Therefore, three series circuits, in which a plurality of bare chips 3 is connected in series, are formed and connected in parallel to the power supply.

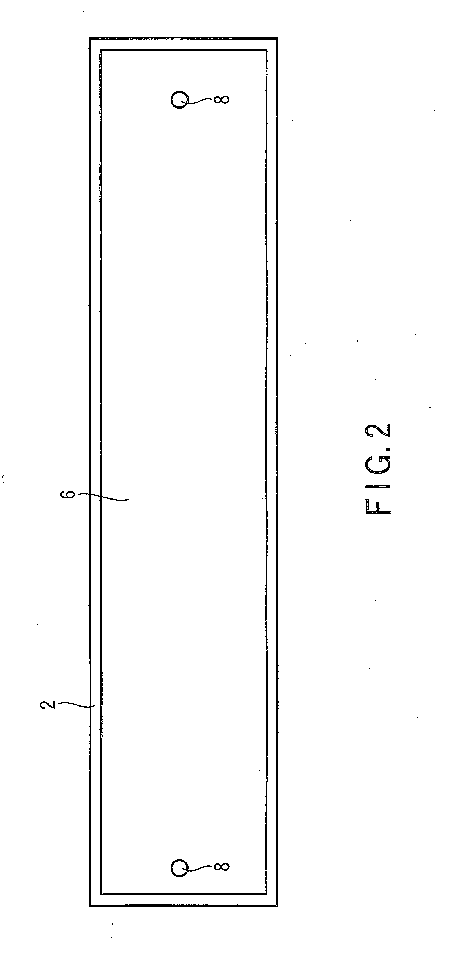

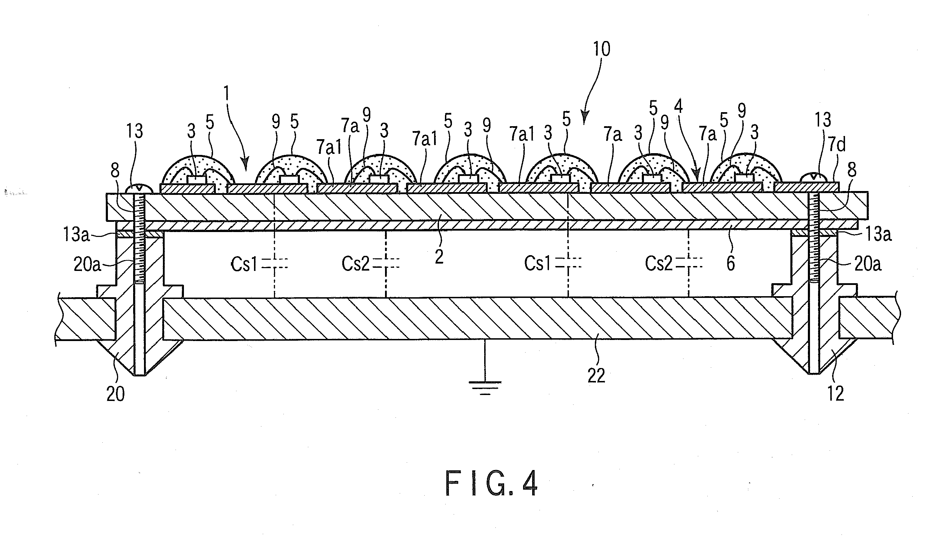

As shown in FIGS. 2 and 4, the conductor layer 6 is formed on the backside of the substrate 2. The conductor layer 6 is a copper foil pattern layer shaped rectangular, similar to the shape of the substrate 2, and is formed inside the substrate 2 to be a little smaller than the substrate 2. The conductor layer 6 is extended in the longitudinal direction from the power feeding wiring 4 on the front side of the substrate 2, that is, the area in which the wiring pattern 7 is formed, and is formed in an area larger than the power feeding wiring 4. The conductor layer 6 may have a three-layer structure similar to the wiring pattern 7, or may be made of other metallic materials.

Next, a lighting apparatus 10 comprising the above light-emitting device 1 will be explained.

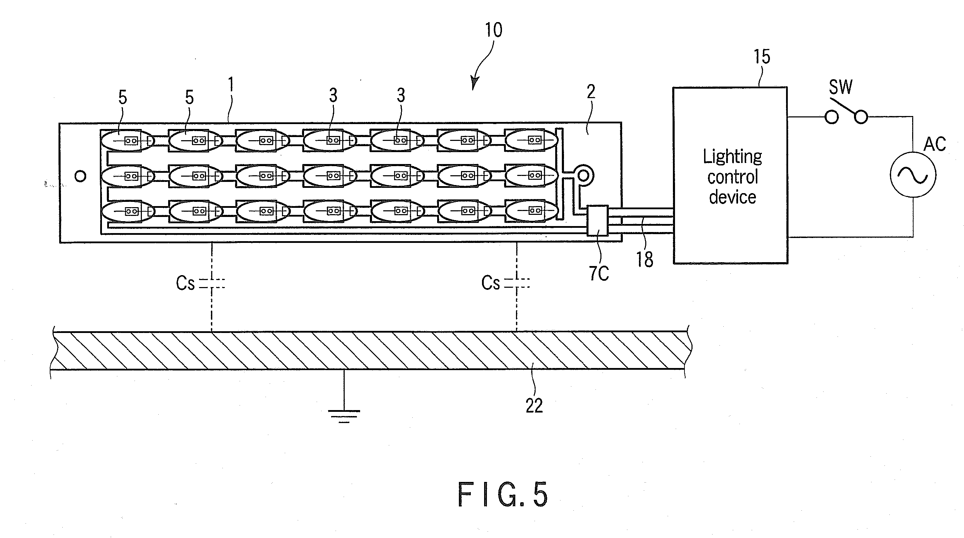

As shown in FIGS. 4 and 5, the light-emitting device 1 is housed in a main body 22 of the lighting apparatus 10, and installed in the main body. The main body 22 is made of metal with conductivity such as aluminum, and is maintained at a ground potential. The main body 22 has two bosses 20, which are made of insulative synthetic resin and installed upright. Each boss 2 is elastically pressed into a fixing hole provided in the main body. Each boss 20 has a screw hole 20a.

The substrate 2 of the light-emitting device 1 is fixed to the main body 22 by a mounting screw 13 as a fixing means or fixing tool to be inserted into the screw hole 20a of the boss 20 through the through hole 8 provided in the substrate 2. The substrate 2 is placed and fixed, so that the backside or the conductor layer 6 is faced to the main body 22, and the front side or the power feeding wiring 4 is positioned opposite to the main body 22. The mounting screw 13 is made of metal, and serves also as a conductive fixing means. A metallic washer 13a is inserted between the boss 20 and the conductor layer 6 of the substrate 2.

In the above configuration, the power feeding wiring 4 and conductor layer 6 are electrically connected by the mounting screw 13, and kept at the same potential. In particular, in FIG. 4, the head of the right-side mounting screw 13 contacts the power supply conductor 7b of the wiring pattern 7, and the shaft contacts the conductor layer 6 through the through hole 8, and its electrical contact with the conductor layer 6 is ensured by the washer 13a. Therefore, the power feeding wiring 4 and conductor layer 6 are electrically connected by the mounting screw 13, and kept at the same potential.

As shown in FIG. 5, the lighting apparatus 10 comprises a lighting control device 15 connected to a commercial alternating-current power supply AC through a power switch SW, and the apparatus main body 22 housing a light-emitting device 1. The lighting control device 15 is constructed by connecting a smoothing capacitor between the output terminals of a full-wave rectifier circuit, for example, and by connecting a direct-current voltage converter circuit and a current detection means to the smoothing capacitor. The lighting control device 15 is electrically connected to the connector terminal 7c of the light-emitting device 1 through a lead wire 18. The light-emitting device 1 is powered by a direct current from the lighting control device 15, and lighting of the bare chip 3 is controlled.

In the lighting apparatus 10 configured as above, when the light-emitting device 1 is powered, the bare chips 3 covered by the fluorescent layer 5 are simultaneously lit, and the light-emitting device 1 is used as a sheet light source to emit white light. While the bare chips 3 are lighting, the light advancing to the substrate 2 is reflected on the surfaces of the mounting pad 7a and power supply conductor 7b, mainly in the direction of using the light.

As the temperature of the light-emitting element such as an LED increases, the light output is lowered, and the service life is reduced. Therefore, for a lighting apparatus using a solid light-emitting element such as an LED and EL element as a light source, it is necessary to prevent a temperature increase in a light-emitting element for increasing the service life and improving the light-emitting efficiency.

In this embodiment, while the bare chips 3 are lighting, the mounting pad 7a functions as a heat spreader to spread the heat generated from each bare chip 3, and accelerates heat radiation. The heat transmitted from the front side to the backside of the substrate 2 is transmitted to the conductor layer 6, and radiated to the outside through the conductor layer 6. This prevents a temperature increase in the bare chip 3.

As shown in FIG. 5, when the main body 22 is close to the power feeding wiring 4 connecting a plurality of bare clips 3, a stray capacitance Cs may be generated. Concerning a stray capacitance Cs, the main body 22 at a ground potential forms one electrode, the power feeding wiring 4 forms the other electrode, and the electrodes are electrostatically coupled through a dielectric material. Therefore, when a noise is superimposed on a power supply line even while the power switch SW is being turned on, a minute current flows in the bare chip 3 as a leakage current, and may cause false lighting of a light-emitting element.

In this embodiment, as the power feeding wiring 4 and conductor layer 6 are electrically connected and kept at a ground potential, a noise superimposed on a power supply line is bypassed to a path in the conductor layer 6, and is prevented from flowing to the power feeding wiring 4. Therefore, it is possible to prevent a micro current from flowing into the bare chip 3 as a leakage current, and to prevent false lighting of the bare chip 3.

In other words, the largeness of the stray capacitance Cs is inversely proportional to the distance between the electrodes, or the distance between the main body 22 and the power feeding wiring 4 or conductor layer 6, and proportional to the electrode area, or the area of the main body 22 and power feeding wiring 4 or conductor layer 6. In this case, as shown in FIG. 4, the distance between the conductor and main body 22 is shorter than the distance between the power feeding wiring 4 and main body 22. Concerning the electrode area, the area of the main body 22 is the same, and the area of the conductor layer 6 is larger than the area of the power feeding wiring 4.

Therefore, the stray capacitance Cs2 generated between the conductor layer 6 and main body 22 is relatively greater than the stray capacitance Cs1 generated between the power feeding wiring 4 and main body 22, that is, Cs1 < Cs2. Therefore, as the impedance between the conductor layer 6 and main body 22 is lower than the impedance between the power feeding wiring 4 and main body 22, a noise is bypassed to a path in the conductor layer 6, and is prevented from flowing into the power feeding wiring 4.

As described above, according to this embodiment, false lighting of the light-emitting element 3 can be prevented in a simple configuration, by forming the conductor layer 5 on the backside of the substrate 2, and setting the potential of the conductor layer 6 to the same as the potential of the power feeding wiring 4 formed on the front side of the substrate 2. Further, as the fixing means to fix the substrate 2 to the main body 22 is also used for electrically connecting the conductor layer 6 and power feeding wiring 4 and setting them at the same potential, a particular connection member is unnecessary, and the structure is simplified. As the conductor layer 6 is formed outside the area in which the power feeding wiring 4 of the front surface of the substrate 2 is formed, the area of the conductor layer 6 can be increased, and the stray capacitance Cs2 can be relatively increased.

Next, a lighting apparatus according to a second embodiment will be explained.

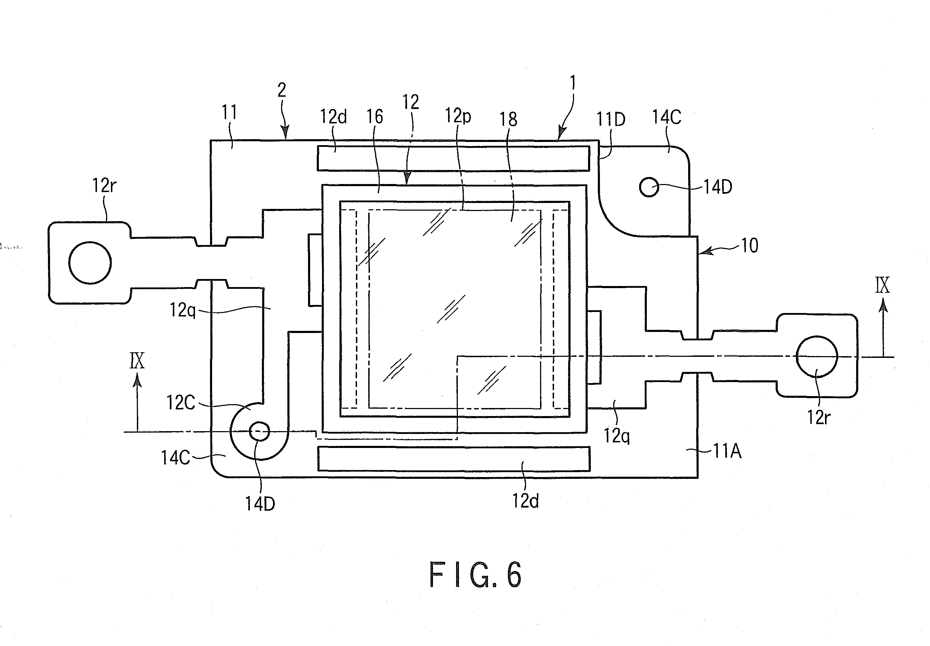

FIGS. 6, 7, 8, and 10 show a light-emitting device in a lighting apparatus according to the second embodiment.

The light-emitting device 1 is of a chip on board (COB) type and includes a substrate 2, a plurality of LED chips 131, which function as semiconductor light-emitting elements, a frame component 16, a translucent seal component 18, and the like, as shown in FIGS. 6 to 9.

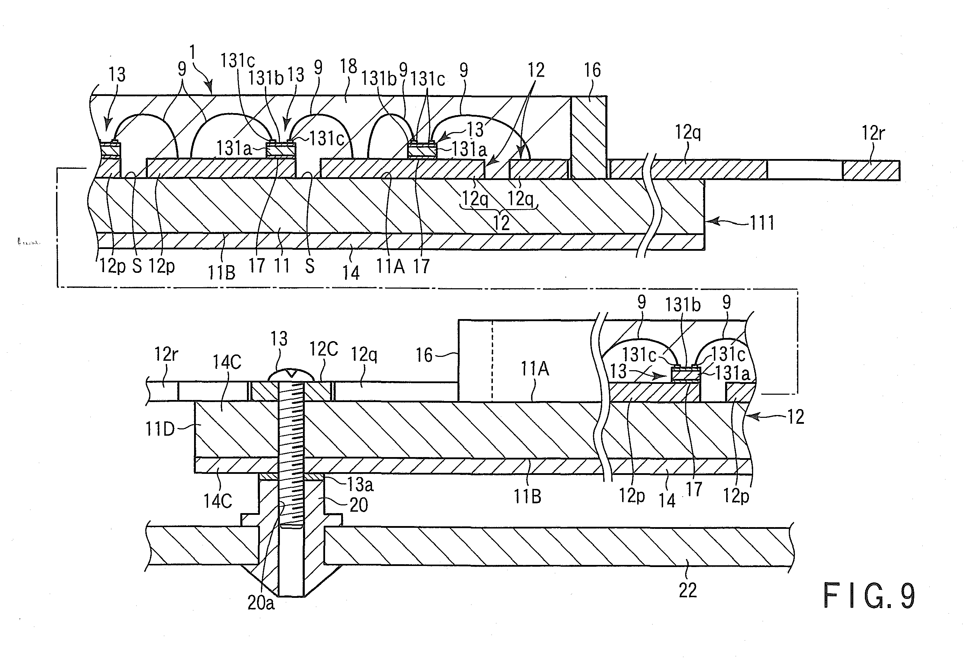

The substrate 2 is a DCB (Direct Copper Bonding) substrate and includes an insulating base 11, an obverse metallic component 12, and a reverse metallic component 14 as shown in FIG. 9. The insulating base 11 is a flat ceramic sheet composed of A1203, AIN, SiN, and the like. As shown in FIG. 6, a mounting surface 11A on which the LED chips 131 are mounted is defined as a front surface of the insulating base 11 and a surface opposite to the mounting surface 11A is defined as a back surface 11B of the insulating base 11. The mounting surface 11A and the back surface 11B of the insulating base 11 are parallel to each other.

The obverse metallic component 12 is formed on the front surface 11A side of the insulating base 11. The obverse metallic component 12 includes pads 12p and power supply portions 12q and constitutes a power supply wiring. The pad 12p and the power supply portion 12q are directly bonded to the mounting surface 11A of the insulating base 11 by a DCB method. The obverse metallic component 12 radiates the heat of the LED chips 131 and reflects the light emitted by the LED chips 131. The reverse metallic component 14 is disposed on the back surface 11B side of the insulating base 11 and directly bonded thereto by the DCB method. The reverse metallic component 14 constitutes a conductive layer. Each of the obverse metallic component 12 and the reverse metallic component 14 is made of copper.

In the direct bonding by the DCB method, each of the copper obverse metallic component 12 and the copper reverse metallic component 14 has a surface on which a copper oxide film is formed, and the copper oxide film is faced the insulating base 11 made of ceramics. An eutectic molten material is formed on a bond interface between the copper obverse metallic component 12 and the copper reverse metallic component 14 and the ceramic insulating base 11 by heating them at a temperature lower than a melting temperature of copper and higher than a melting temperature of the copper oxide film, by a heating furnace. The obverse metallic component 12 and the reverse metallic component 14 are bonded to the mounting surface 11A or to the back surface 11B of the insulating base 11 by the eutectic molten material.

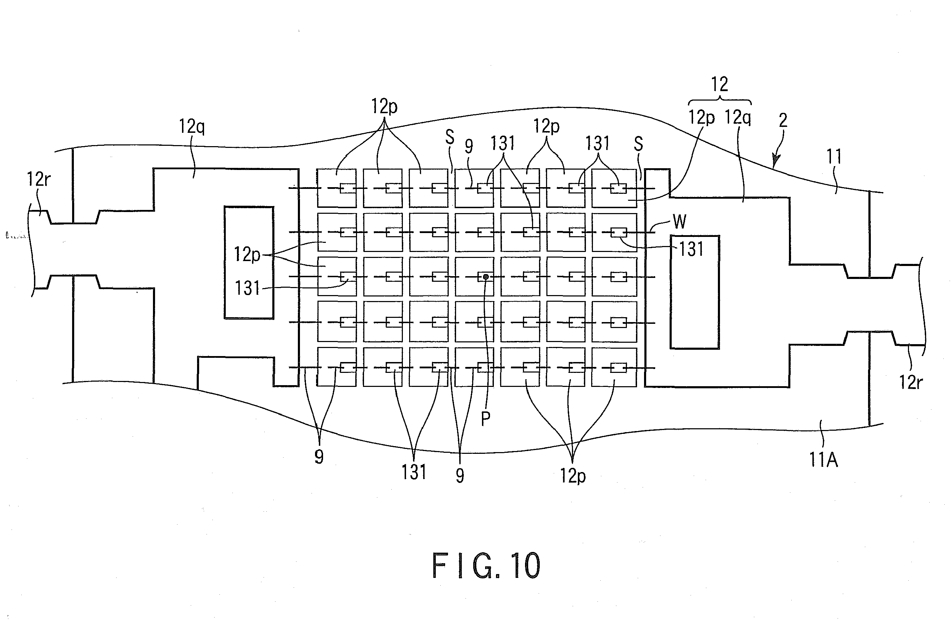

The obverse metallic component 12, which is directly bonded to the mounting surface 11A, is configured of the pads 12p divided in a matrix state. As shown in FIG. 10, the respective pads 12p are arranged squarely at the same gaps in the matrix state corresponding to the disposition of the LED chips 131.

The power supply portions 12q are disposed on both the sides of a region of the pads 12p arranged in away therefrom with predetermined gaps. The power supply portions 12q in a range, which overlaps the mounting surface 11A, are directly bonded to the mounting surface 11A. Free end portions of the respective power supply portions 12q, which extend straightly along the mounting surface 11A of the insulating base 11 to the outside, are used as power supply terminals 12r. As shown in FIG. 9, the power supply terminals 12r extend in parallel with the mounting surface 11A in a thickness direction of the insulating base 11 without changing their positions. The power supply terminals 12r may be formed in a crank shape so as to be bent in the thickness direction of the insulating base 11 away from the mounting surface 11A and further bent in a direction parallel with the mounting surface 11A ahead of the above bent position.

The power supply portions 12q are formed symmetrically about a point with respect to a center of the insulating base 11, and the power supply terminals 12r of the power supply portions 12q are connected to power supply insulation covered wires (not shown). One of the power supply portions 12q includes a conductive portion 12c extending to one corner portion of the substrate 2.

The light-emitting device 1 includes LED series circuits in each of which the LED chips 131 are connected in series and which are arranged in parallel. The light-emitting device 1 shown in FIG. 10 connects the five LED series circuits, in each of which the seven LED chips 131 are connected in series, to the power supply portions 12q. A pair of the power supply portions 12q that supply power to the respective LED series circuits is arranged on both the outsides of the region of the pads 12p. All the LED chips 131 may be connected in series and supplied with power. In this case, the power supply portions 12q are arranged adjacent to the pads 12p on both the ends of the series circuits.

Surfaces of the pads 12p and the power supply portions 12q which are the obverse metallic component 12 are laminated with metal layers which are greatly thinner than the obverse metallic component 12. Each of the metal layers is configured of a base plating layer plated on a surface of the obverse metallic component 12 in a thickness of about 3 µm and a surface plating layer plated to an outside of the base plating layer in a thickness of about 0.3 µm. The base plating layer is a nickel plating layer, and the surface plating layer is a plating layer of any of copper (Cu), silver (Ag), and gold (Au). When the surface plating layer is formed of a silver plating layer, a light reflection amount in the respective pads 12p that form the obverse metallic component 12 is increased in comparison with a case in which the plating layer is not formed.

The pads 12p and the power supply portions 12q of the obverse metallic component 12 are formed in a determined pattern on the front surface of the mounting surface 11A of the insulating base 11 by the following procedure. First, a metal sheet, a copper sheet in the fifth embodiment, having a uniform thickness or is punched to a predetermined pattern by a dies of a press machine. The punched copper sheet is directly bonded to the mounting surface 11A by interface bonding such as eutectic bonding and diffusion bonding. After the cupper sheet is subjected to a plating treatment, bridge portions, which connect the pads 12p and the power supply portions 12q of the copper sheet bonded to the mounting surface 11A, are cut off and removed. With the operation, the independent pads 12p and power supply portions 12q are formed.

The pads 12p and the power supply portions 12q may be formed by other method. That is, after a copper sheet formed in a predetermined thickness and size is directly bonded to the mounting surface 11A of the insulating base 11, the copper sheet is etched to remove unnecessary portions and to have a desired pattern. Remaining necessary portions, that is, the pads 12p and the power supply portions 12q of the obverse metallic component 12 are subjected to a plating treatment thereafter.

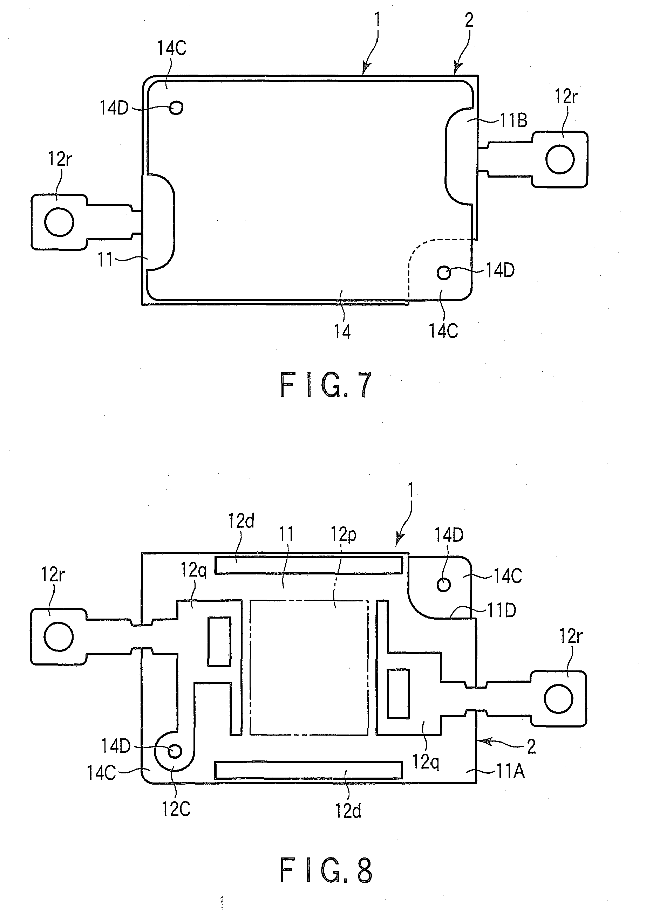

The reverse metallic component 14 is directly bonded to the back surface 11B of the insulating base 11 by the DCB method. The reverse metallic component 14 is formed to prevent warping of the substrate 2 in a manufacturing process and to radiate heat. The reverse metallic component 14 covers an approximately entire region of the back surface 11B of the insulating base 11 as shown in FIG. 7. The substrate 2 includes a plurality of, e.g., two fastening portions 14C at two locations integrally therewith as shown in FIGS. 6 to 8.

The fastening portions 14C include screw-passing holes 14D. One of the screw passing holes 14D penetrates the conductive portion 12c, insulating base 11, and reverse metallic component 14.

Thicknesses of the pads 12p and the power supply portions 12q of the obverse metallic component 12 and a thickness of the reverse metallic component 14, which are directly bonded to the insulating base 11 as sheet metal materials, are selected in a range of 200 µm to 500 µm so that the pads 12p, the power supply portions 12q and the reverse metallic component 14 have target thickness when they are directly bonded to the insulating base 11. Since the obverse metallic component 12 and the reverse metallic component 14 are greatly thicker than the metal plating layers, the obverse metallic component 12 and the reverse metallic component 14 have a mechanical strength.

The thickness of the reverse metallic component 14 is thinner than the thickness of the power supply portions 12q of the obverse metallic component 12. When the substrate 2 is manufactured by the DCB method, if a temperature of the substrates 2 rises due to the direct bond and then drops to a room temperature, there is a tendency that the obverse metallic component 12 side becomes convex and the reverse metallic component 14 side becomes concave. The thickness of the reverse metallic component 14 is determined according to a pattern of the obverse metallic component 12 to suppress warping of the substrate 2.

The respective LED chips 131 may use semiconductor light-emitting elements that have various types of emission color. In the fifth embodiment, LED chips that emit blue light are employed. The LED chips 131 are semiconductor bare chips, each of which is configured by layering an element substrate 131a, a semiconductor emission layer 131b, and an element electrode 131c as shown in FIG. 9. The element substrate 131a is made of an insulation material such as sapphire. The semiconductor emission layer 131b is laminated on the element substrate 131a and emit monochromatic blue light. The element electrode 131c is configured of a pair of a positive electrode and a negative electrode is formed on the semiconductor emission layer 131b.

Since the LED chips 131 are mounted on the mounting surface 11A side of the insulating base 11, a surface of the element substrate 131a on an opposite side on which the semiconductor emission layer 131b is laminated is fastened to each pad 12p by a die-bonding material 17. The die-bonding material 17 is a silver paste or a resin adhesive such as a transparent silicone resin.

The respective LED chips 131 are mounted in an atmosphere heated to about 300°C. In this case, warping of the substrate 2 is controlled by adjusting a difference between an area occupied by the pads 12p and the power supply portions 12q of the obverse metallic component 12 in the mounting surface 11A of the insulating base 11 and an area occupied by the reverse metallic component 14 in the back surface 11B of the insulating base 11. That is, the warping of the insulating base 11 is suppressed based on a volume difference converted based on respective areas and thicknesses of the obverse metallic component 12 bonded to the front surface of the insulating base 11 and the reverse metallic component 14 bonded to the back surface 11B. Since the obverse metallic component 12 is formed into a pattern configured by the pads 12p and the power supply portions 12q, the obverse metallic component 12 has an area smaller than that of the reverse metallic component 14. When the obverse metallic component 12 and the reverse metallic component 14 have the same thickness, it is predicted that the substrate 2 is warped so that the mounting surface 11A side of the insulating base 11 becomes convex and the back surface 11B side thereof becomes concave. Thus, the thickness of the reverse metallic component 14 is made thinner than the thickness of the obverse metallic component 12.

When the thickness of the reverse metallic component 14 is not adjusted to the obverse metallic component 12, unallowable warping may be generated in the substrate 2 before a process in which the LED chips 131 are mounted. When warping is generated in the substrate 2, it is difficult to appropriately manage a thickness of the die-bonding material 17. When the thickness of the die-bonding material 17 is uneven, the LED chips 131 may be defectively mounted. When the LED chips 131 are insufficiently mounted, a capability of radiating the heat generated while the LED chips 131 are lit to the pads 12p through the die-bonding material 17 is lowered. Thus, a light emission performance of the LED chips 131 is deteriorated and a life of the LED chips 131 is also reduced.

When warping is happened while the LED chips 131 are lit, a central portion of the substrate 2, which should be in intimate contact with a radiation component, may be away from the radiation component. A heat transfer function of a portion exfoliated from the radiation component is lowered, and a so-called heat spot is formed. An emission performance of the LED chips 131 in a portion in which the heat spot is formed is deteriorated and a life is reduced. The light-emitting device 1 of the fifth embodiment suppresses warping of the substrate 2 small before the LED chips 131 are mounted on the substrate 2 and while the LED chips 131 are lit by making the thickness of the reverse metallic component 14 smaller than the thicknesses of the pads 12p and the power supply portions 12q of the obverse metallic component 12. Since a disadvantage that the substrate 2 of the light-emitting device 1 is warped more than an allowable amount is alleviated, quality of the light-emitting device 1 is improved.

Since the lighting apparatus 10 includes the light-emitting device 1 in which the thickness of the reverse metallic component 14 is smaller than the thicknesses of the pads 12p and the power supply portions 12q of the obverse metallic component 12, occurrence of warping, in which the mounting surface 11A side of the insulating base 11 becomes convex and the back surface 11B side thereof becomes concave due to a volume ratio of the metal components formed on the front surface and the back surface of the insulating base 11, can be suppressed while the lighting apparatus 10 is lit. Further, since the central portion of the substrate 2 is unlikely to be exfoliated from the radiation component by suppressing occurrence of warping in the substrate 2, the heat spot is not formed in the substrate 2.

As shown in FIGS. 9 and 10, the element electrodes 131c of the respective LED chips 131 are electrically connected to the pads 12p and the power supply portions 12q by bonding wires 9. In this case, the element electrodes 131c of one electrode are connected to the pads 12p on which the LED chips 131 are mounted by bonding wires 9, and the element electrodes 131c of the other electrode are connected to other pads 12p adjacent to the pads 12p on which the LED chips 131 are mounted by bonding wires 9. The LED chips 131, which are connected through the bonding wires 9 and the pads 12p, are connected to each other in series.

An element electrode 131c of an LED chip 131, positioned at an end of a train of the LED chips connected in series, is connected to a power supply portion 12q adjacent to a pad 12p on which the LED chip 131 is mounted by a bonding wire 9, and a pad 12p, on which an LED chip 131 positioned at the other end of the train of the LED chips is mounted, is connected to the other power supply portion 12q by a bonding wire 9. Trains of LED chips are connected in parallel between power supply portions 12q positioned on both sides in a direction where the trains extend.

As shown in FIGS. 6 and 9, the light-emitting device 1 includes a frame component 16 arranged partially surrounding the pads 12p and the power supply portions 12q. The frame component 16 has a height enough to accommodate the respective LED chips 131 mounted on the pads 12p and the bonding wires 9 that connect the respective LED chips 131 therein and is adhered on the mounting surface 11A of the substrate 2.

The LED chips 131 and the bonding wires 9 are buried by the seal component 18 filled in an inside surrounded by the frame component 16. The seal component 18 is made of a transparent resin or a transparent silicone resin in the fifth embodiment and contains a fluorescent material therein. The fluorescent material radiates specific color light when the fluorescent material is excited by a part of blue light radiated by the LED chips 131. In the fifth embodiment, with respect to the blue light radiated by the LED chips 131, a yellow fluorescent material that excites and radiates yellow light, a red fluorescent material that excites and radiates red light, or a green fluorescent material that excites and radiates green light is blended with the seal component 18 at a preset blend rate.

As shown in FIG. 9, the light-emitting device 1 is housed in a main body 22 of the lighting apparatus 10, and installed in the main body. The main body 22 is made of metal with conductivity such as aluminum, and is maintained at a ground potential. The main body 22 has two bosses 20, which are made of insulative synthetic resin and installed upright. Each boss 2 is elastically pressed into a fixing hole provided in the main body. Each boss 20 has a screw hole 20a.

The fastening portions 14C of the substrate 2 of the light-emitting device 1 is fixed to the main body 22 by mounting screws 13 as a fixing means to be inserted into the screw hole 20a of the boss 20 through the through hole 8 provided in the substrate 2. The substrate 2 is placed and fixed, so that the backside or the reverse metallic component 14 serving as a conductor layer is faced to the main body 22, and the front side or the obverse metallic component 12 serving as a power feeding wiring is positioned opposite to the main body 22. The mounting screw 13 is made of metal, and serves also as a conductive fixing means. A metallic washer 13a is inserted between the boss 20 and the reverse metallic component 14 of the substrate 2.

In the above configuration, the obverse metallic component 12 and the reverse metallic component 14 are electrically connected to each other by the mounting screw 13, and kept at the same potential. In particular, in FIG. 49 the head of the left-side mounting screw 13 contacts the conductor portion 12c of the power supply portion 12q, and the shaft passed through the through hole contacts the reverse metallic component 14, and its electrical contact with the reverse metallic component 14 is ensured by the washer 13a. Therefore, the obverse metallic component 12 and the reverse metallic component 14 are electrically connected to each other by the mounting screw 13, and kept at the same potential.

As described above, according to this embodiment, false lighting of the light-emitting element 3 can be prevented in a simple configuration, by forming the reverse metallic component 14 on the backside of the substrate 2, and setting the potential of the reverse metallic component 14 to the same as the potential of the observe metallic component 12 formed on the front side of the substrate 2. Further, as the fixing means to fix the substrate 2 to the main body 22 is also used for electrically connecting the obverse metallic component 12 and the reverse metallic component 14 and setting them at the same potential, a particular connection member is unnecessary, and the structure is simplified. As the reverse metallic component 14 is formed to extend outside of the area in which the obverse metallic component 12 on the front surface of the substrate 2 is formed, the area of the reverse metallic component 14 can be increased, and the stray capacitance Cs2 can be relatively increased.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

For example, a power feeding wiring and conductor layer may be connected through a resistive component or capacitive component. A resistor element may be used as a resistive component, and a capacitor may be used as a capacitive component. In this case, when a conductor layer and main body fall into electrically non-conductive state due to any defect, an excessive current is prevented from flowing into the main body.

A conductor layer and power feeding wiring may be connected by means of a conductor such as a lead wire, and may be set to the same potential. A means to set the same potential is not limited.

A substrate may use a base plate made of metallic material with excellent heat conductivity and heat radiation. In this case, an insulating layer may be formed on one side or both sides of a base plate.

A method of mounting a light-emitting element on a substrate is not limited. For example, a chip-on-board method directly inserts a bare chip into a substrate, and a soldering method solders packaged surface-mounted components.

A lighting apparatus with increased light intensity may be connecting a plurality of light-emitting devices in series or parallel. Further, a lighting apparatus is applicable to a lighting fixture used indoor and outdoor, and a display.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. Lighting apparatus **characterized by** comprising:
a conductive main body (22) at a ground potential;
a light-emitting device (1) in the main body, comprising an insulative substrate (2), a plurality of light-emitting elements (3) mounted on a front side of the substrate, a power feeding wiring (4) electrically connecting the light-emitting elements, and a conductor layer (6) on a backside of the substrate, electrically connected to the power feeding wiring at a potential higher than a ground potential; and
a lighting control device (15) configured to supply power to the light-emitting device.

2. The lighting apparatus of claim 1, **characterized in that** the power feeding wiring (4) and conductor layer (6) are electrically connected to each other by a conductive fixing tool (13) for fixing the substrate (2) to the main body (22), and maintained at substantially the same potential.

3. The lighting apparatus of claim 2, **characterized in that** the fixing tool comprises a plurality of bosses provided upright in the main body, and a conductive mounting screw to fix the substrate to the bosses, and the mounting screw electrically contact the power feeding wiring and conductor layer.

4. The lighting apparatus of any of claims 1 to 3, **characterized in that** the conductor layer (6) is configured to extend to an outside of an area in which the power feeding wiring (4) is formed.

5. The lighting apparatus of claim 4, **characterized in that** the conductor layer (6) has an area larger than the power feeding wiring (4).

6. The lighting apparatus of claim 4 or 5, **characterized in that** the power feeding wiring (4) comprises a wiring pattern (7) on the surface of the substrate (2), on the wiring pattern the light-emitting elements (3) are mounted, and bonding wires (9) electrically connecting the light-emitting elements.

7. The lighting apparatus of any of claims 1 to 6, **characterized in that** the substrate (2) is arranged so that the conductor layer (6) is positioned closer to the main body than the power feeding wiring (4).

8. The lighting apparatus of any of claims 1 to 7, **characterized in that** the light-emitting device (1) comprises a fluorescent layer (5) configured to cover the light-emitting elements (3) and power feeding wiring (4).
